# FASCICULE DE BREVET EUROPEEN

(11) **EP 3 503 292 B1**
(45) Date de publication et mention de la délivrance du brevet: **14.07.2021**
(21) Numéro de dépôt: 18214879.1
(22) Date de dépôt: 20.12.2018
(51) Int. Cl.: H01Q 1/32, H01Q 1/38, H01Q 7/00, H01Q 7/08, H05K 3/00, H05K 5/00, H05K 7/00

(54) **BOITIER ANTENNE POUR VEHICULE AUTOMOBILE**
ANTENNENGEHÄUSE FÜR KRAFTFAHRZEUG
ANTENNA UNIT FOR A MOTOR VEHICLE

(30) Priorité: 20.12.2017 FR 1762684
(43) Date de publication de la demande: 26.06.2019
(73) Titulaire: Valeo Comfort and Driving Assistance, 94046 Créteil Cedex (FR)
(72) Inventeur: DESCHAMPS, Maxime, 94046 Créteil CEDEX (FR); BONIFACE, Sébastien, 94046 Créteil (FR)
(74) Mandataire: Delaval, Guillaume Laurent

(56) Documents cités:
- EP-A1- 2 937 821
- WO-A1-2015/168459
- FR-A1- 2 748 161
- US-A1- 2007 206 365

## Description

### DOMAINE TECHNIQUE DE L'INVENTION

La présente invention concerne un boîtier antenne pour véhicule automobile. Elle trouve une application particulière mais non limitative dans le domaine des véhicules automobiles.

### ARRIÈRE-PLAN TECHNOLOGIQUE DE L'INVENTION

Dans le domaine des véhicules automobiles, un boîtier antenne pour véhicule automobile, connu de l'homme du métier, est un boîtier antenne NFC (« Near Field Communication » en anglais) fermé qui comprend une ouverture à travers de laquelle une platine support comprenant une antenne intégrée et des composants électroniques associés peut passer pour être disposée dans ledit boîtier et entourée de résine. La résine est coulée dans ladite ouverture puis polymérisée. Le boîtier antenne est par la suite refroidi. Le boîtier antenne est en matériau plastique.

Le document EP 2937821 divulgue un boîtier antenne pour véhicule automobile selon le préambule de la revendication 1.

Un inconvénient de cet état de la technique antérieur est que les performances de l'antenne intégrée sont limitées en raison de sa proximité avec les composants électroniques qui perturbent son champ magnétique et donc son signal d'antenne.

Dans ce contexte, la présente invention vise à résoudre l'inconvénient précédemment mentionné.

### DESCRIPTION GENERALE DE L'INVENTION

A cette fin l'invention propose un boîtier antenne pour véhicule automobile dans lequel une résine à polymériser peut être coulée, selon lequel ledit boîtier antenne comprend :
- un réceptacle adapté pour accueillir une platine support primaire et une platine support secondaire et comprenant au moins un clip de fixation primaire ;
- un couvercle comprenant au moins un clip de fixation secondaire adapté pour coopérer avec ledit au moins un clip de fixation primaire, ledit couvercle étant adapté pour fermer ledit boîtier antenne de sorte à laisser une ouverture pour couler ladite résine dans ledit boîtier antenne ;
- ladite platine support primaire formant une antenne ; et
- ladite platine support secondaire adaptée pour être disposée en regard de ladite antenne et comprenant des composants électroniques adaptés pour coopérer avec ladite antenne.

Le réceptacle comprend au moins un muret disposé le long d'un bord dudit réceptacle de manière à augmenter la rigidité du réceptacle dans les phases d'assemblage du réceptacle avec le couvercle et de manipulation du boîtier antenne lors du coulage de la résine.

Ainsi, comme on le verra en détail par la suite, le fait de séparer le boîtier en deux parties, le réceptacle et le couvercle, et d'ajouter des clips de fixation primaires et secondaires, permet d'utiliser deux platines support différentes, l'une comprenant les composants électroniques et l'autre étant l'antenne. On obtient ainsi une antenne déportée par rapport aux composants électroniques ce qui améliore les performances de ladite antenne. Son signal d'antenne est moins perturbé. Par ailleurs, le fait d'utiliser des clips de fixation primaires et secondaires permet que le réceptacle et le couvercle restent bien assemblés pendant le procédé d'assemblage et avant que la résine ne polymérise, et également pendant la manipulation du boîtier antenne après que la résine a polymérisée.

Selon des modes de réalisation non limitatifs, le boîtier antenne peut comporter en outre une ou plusieurs caractéristiques supplémentaires parmi les suivantes.

Selon un mode de réalisation non limitatif, ledit réceptacle comprend une pluralité de clips de fixation primaires et ledit couvercle comprend une pluralité de clips de fixation secondaires.

Selon un mode de réalisation non limitatif, ledit couvercle comprend en outre au moins un contre-appui adapté pour appuyer sur la platine support secondaire lorsque ledit boîtier antenne est fermé.

Selon un mode de réalisation non limitatif, ledit couvercle comprend en outre une pluralité de godrons disposés le long d'un bord dudit couvercle sur une arrête.

Selon un mode de réalisation non limitatif, ledit réceptacle comprend en outre au moins une griffe adaptée pour passer un faisceau de connexions électriques.

Selon un mode de réalisation non limitatif, ledit au moins un clip de fixation primaire comprend une largeur inférieure à celle dudit au moins un clip de fixation secondaire.

Selon un mode de réalisation non limitatif, ledit au moins un clip de fixation primaire et ledit au moins un clip de fixation secondaire comprennent une longueur comprise entre 3,3 millimètres et 3,8 millimètres.

Selon un mode de réalisation non limitatif, ledit réceptacle comprend un espace primaire entre ledit au moins un clip de fixation primaire et un bord dudit réceptacle.

Selon un mode de réalisation non limitatif, ledit espace primaire est en forme de U.

Selon un mode de réalisation non limitatif, ladite antenne est une antenne en champ proche.

Selon un mode de réalisation non limitatif, ladite antenne est déportée par rapport à ladite platine support secondaire.

Selon un mode de réalisation non limitatif, ladite platine support primaire est une carte électronique flexible ou une carte à circuit imprimé.

Selon un mode de réalisation non limitatif, ledit réceptacle et/ou ledit couvercle comprend une gorge.

Selon un mode de réalisation non limitatif, le réceptacle comprend une pluralité de murets, deux murets étant répartis de part et d'autre d'un clip de fixation primaire.

Il est en outre proposé un procédé d'assemblage d'un boîtier antenne pour véhicule automobile selon la revendication 1, ledit boîtier antenne étant adapté pour accueillir une platine support primaire formant une antenne et une platine support secondaire, et dans lequel une résine à polymériser peut être coulée, selon lequel ledit procédé d'assemblage comprend :
- le positionnement de ladite platine support primaire et de ladite platine support secondaire dans un réceptacle dudit boîtier antenne ;
- la fixation d'un couvercle sur ledit réceptacle pour fermer ledit boîtier antenne de sorte à laisser une ouverture pour couler ladite résine, ladite fixation étant réalisée au moyen d'au moins un clip de fixation primaire dudit réceptacle coopérant avec au moins un clip de fixation secondaire dudit couvercle ;
- la mise en compression dudit réceptacle sur ledit couvercle ou inversement ;
- le coulage de ladite résine dans ledit boîtier antenne via ladite ouverture ;
- la polymérisation de ladite résine ;
- le refroidissement dudit boîtier antenne.

### BREVE DESCRIPTION DES FIGURES

L'invention et ses différentes applications seront mieux comprises à la lecture de la description qui suit et à l'examen des figures qui l'accompagnent.
- la figure 1 représente une vue éclatée d'un boîtier antenne pour véhicule automobile selon un mode de réalisation non limitatif de l'invention, ledit boîtier comprenant un réceptacle, un couvercle, une platine support primaire et une platine support secondaire ;
- la figure 2 représente une vue en perspective assemblée du boîtier antenne de la figure 1, selon un mode de réalisation non limitatif ;
- la figure 3a représente une vue de la platine support secondaire de la figure 1 selon un mode de réalisation non limitatif ;
- la figure 3b illustre une vue de la platine support primaire du boîtier antenne des figures 1 et 2 comprenant des pistes sérigraphiées, selon un mode de réalisation non limitatif ;
- la figure 3c illustre une vue de la platine support primaire de la figure 3b comprenant une ferrite, selon un mode de réalisation non limitatif ;
- La figure 4 représente le couvercle du boitier antenne de la figure 1, selon un mode de réalisation non limitatif ;
- la figure 5 représente le réceptacle du boîtier antenne de la figure 1, selon un mode de réalisation non limitatif ;
- la figure 6 illustre une vue schématique d'un assemblage entre un clip de fixation primaire du réceptacle de la figure 5 et un clip de fixation secondaire du couvercle de la figure 4, selon un mode de réalisation non limitatif ;
- la figure 7 illustre une vue selon un plan de coupe référencé A-A du réceptacle de la figure 5, ledit réceptacle comprenant un clip de fixation primaire selon un mode de réalisation non limitatif ;
- la figure 8 illustre une vue en coupe transversale du réceptacle et du couvercle du boîtier antenne de la figure 1, ledit réceptacle comprenant un muret disposé entre deux clips de fixation primaires, selon un mode de réalisation non limitatif ;
- la figure 9a illustre une empreinte côté platine support primaire d'une résine qui a été coulée dans le boîtier antenne de la figure 1, selon un mode de réalisation non limitatif ;
- la figure 9b illustre une empreinte côté platine support secondaire d'une résine qui a été coulée dans le boîtier antenne de la figure 1, selon un mode de réalisation non limitatif ;
- la figure 10 illustre le boitier antenne de la figure 1, ledit boitier antenne comprenant un faisceau de connexions électriques et étant monté sur une carrosserie du véhicule selon un mode de réalisation non limitatif ; et
- la figure 11 illustre un diagramme d'un procédé d'assemblage du boîtier antenne de la figure 1, selon un mode de réalisation non limitatif.

### DESCRIPTION DE MODES DE REALISATION DE L'INVENTION

Les éléments identiques, par structure ou par fonction, apparaissant sur différentes figures conservent, sauf précision contraire, les mêmes références.

L'invention concerne un boîtier antenne 1 pour véhicule automobile.

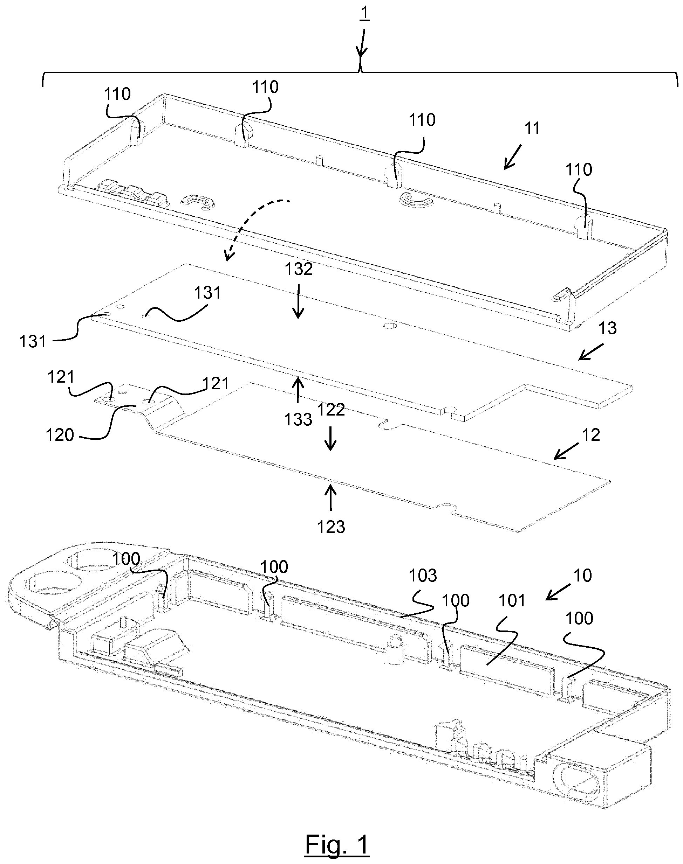

Ledit boîtier antenne 1 est décrit en référence aux figures 1 à 10.

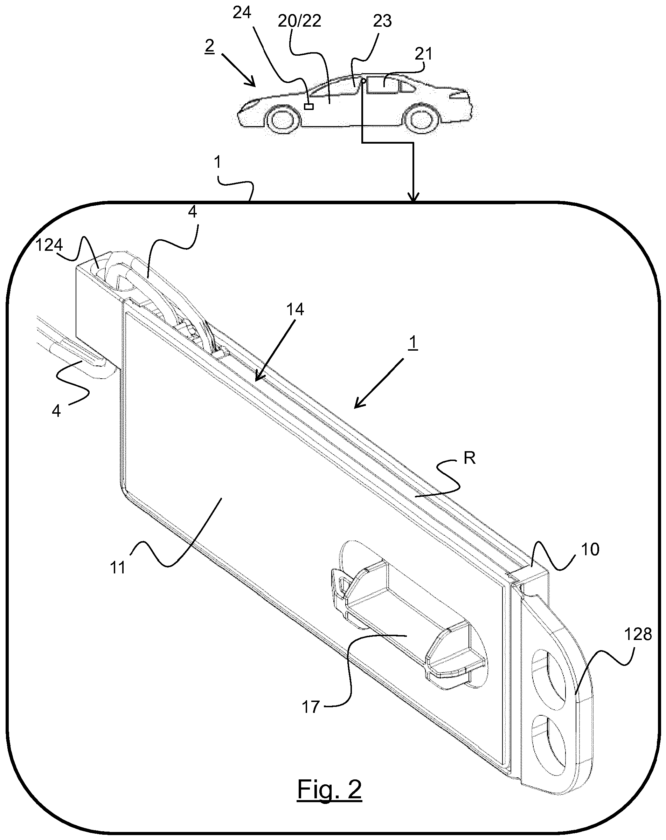

Tel qu'illustré sur les figures 1 et 2, le boîtier antenne 1 comprend :
- un réceptacle 10 adapté pour accueillir une platine support primaire 12 et une platine support secondaire 13 ;
- un couvercle 11 adapté pour fermer ledit boîtier antenne 1 ;
- ladite platine support primaire 12 formant une antenne ; et
- ladite platine support secondaire 13.

Dans un mode de réalisation non limitatif, le boîtier antenne 1 comprend une épaisseur sensiblement égale à 6 mm (millimètres). C'est un boîtier antenne 1 fin.

Dans la suite de la description, la platine support primaire 12 est également appelée antenne 12.

Ledit boîtier antenne 1 est en matériau plastique. Il permet de protéger l'antenne 12 et permet de la monter sur le véhicule automobile 2. Par ailleurs, le boîtier antenne 1 permet de laisser passer les ondes en champ proche. Il reste ainsi perméable aux champs magnétiques.

Le boîtier antenne 1 étant en deux parties, le réceptacle 10 et le couvercle 11, il permet d'accéder à la platine support primaire 12 et à la platine support secondaire 13 pour effectuer un contact électrique entre les deux avant de refermer ledit boîtier antenne 1.

On notera que dans le cas de l'état de la technique antérieur mentionné, après la polymérisation, lors du refroidissement du matériau plastique du boîtier antenne, il y a une déformation des surfaces formant le boîtier antenne qui sont sensiblement parallèles entre elles ce qui entraîne que le positionnement de ladite antenne n'est pas maîtrisé. C'est ce qu'on appelle un « effet boîte » lié au refroidissement du matériau plastique du boîtier antenne. En conséquence, les performances de communication de ladite antenne ne sont pas uniformes d'un véhicule automobile à un autre pour un même constructeur automobile par exemple.

Le fait d'avoir séparé le boîtier antenne 1 en deux parties entraîne qu'il n'y a plus d'« effet boîte » au niveau des surfaces formant le boîtier antenne 1, à savoir au niveau du fond du réceptacle 10 et du fond du couvercle 11.

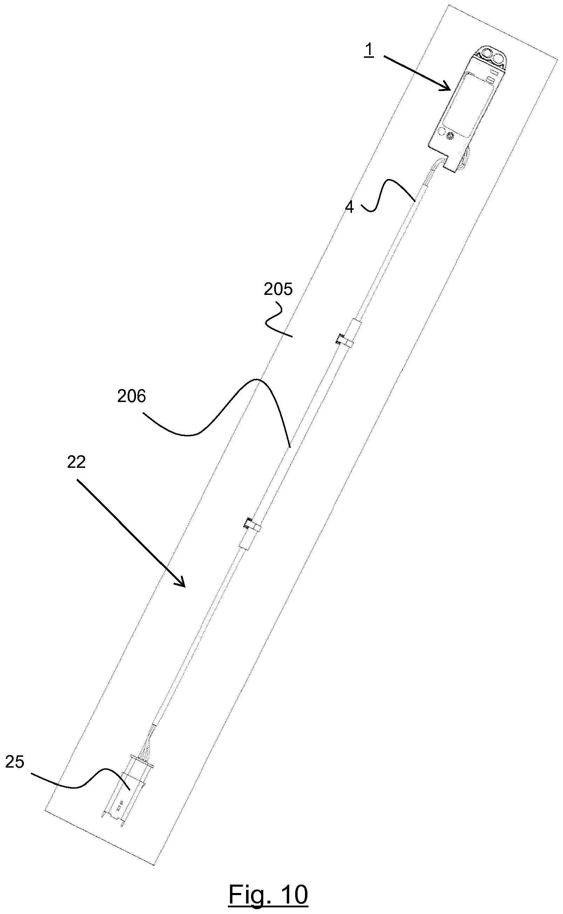

Tel qu'illustré sur la figure 2, le véhicule automobile 2 comprend :
- une carrosserie 20 ;
- un habitacle 21 ;
- une garniture 22 de carrosserie ;
- une unité de contrôle 24 ;
- un connecteur 25 (illustré sur la figure 10).

Dans un mode de réalisation non limitatif, la carrosserie 20 est un ouvrant.

Dans une variante de réalisation non limitative, l'ouvrant est une portière.

Cette variante est prise comme exemple non limitatif dans la suite de la description.

Le boîtier antenne 1 est adapté pour être disposé entre la portière et sa garniture 22, à savoir il se trouve en dessous de la garniture 22 et à l'extérieur de la carrosserie 20.

En particulier, dans un mode de réalisation non limitatif, le boîtier antenne 1 est disposé dans le montant de la portière. Le montant est une zone verticale de la portière qui se trouve au niveau de la vitre du véhicule automobile 2.

Cela évite à un utilisateur de se baisser lorsqu'il rapproche un identifiant de la portière. C'est ainsi un endroit plus ergonomique car l'utilisateur peut facilement voir un marquage d'identification indiquant l'emplacement où approcher l'identifiant du véhicule automobile 2. L'identifiant est approché ou plaqué contre la portière au niveau du marquage d'identification.

Dans un mode de réalisation non limitatif, l'identifiant est un badge, un téléphone intelligent appelé « Smartphone » en anglais, une clef etc.

On notera que le montant est une zone non fermée qui n'est donc pas hermétique. Il ne peut être rempli de résine pour étanchéifier le boîtier antenne 1, contrairement à une poignée de portière. Ce n'est ainsi pas une zone étanche.

Dans un mode de réalisation non limitatif, le boîtier antenne 1 assure une fonction d'accès véhicule qui comprend l'identification d'un identifiant de véhicule automobile et le déverrouillage du véhicule automobile. Dans un exemple non limitatif, cette fonction d'accès véhicule est intéressante dans le cas de véhicules électriques partagés.

La carrosserie 20 comprend une face intérieure (non illustrée) dirigée vers l'habitacle 21 du véhicule automobile 20, une face extérieure 205 (illustrée sur la figure 10) dirigée vers l'extérieur du véhicule automobile 20 et une goulotte 206 (illustrée sur la figure 10).

Dans un mode de réalisation non limitatif, le boîtier antenne 1 est disposé de sorte que ladite antenne 12 se trouve en regard de la garniture 22 et ladite platine support secondaire 13 (décrite plus loin) comprenant les composants électroniques 130 se trouve en regard de la portière, à savoir de la carrosserie 20 du véhicule automobile. Plus particulièrement, la platine support secondaire 13 se trouve en regard de la face extérieure 205 de la carrosserie 20.

La garniture 22 de la portière 20 appelée également décoration recouvre l'ensemble du boîtier antenne 1 et un faisceau de connexions électriques 4.

C'est ainsi une pièce en contrepartie sur la portière 20. Dans un mode de réalisation non limitatif, elle est clippée sur la portière 20. La garniture 22 est légèrement galbée.

Tel qu'illustré sur la figure 10, le faisceau de connexions électriques 4 s'étend le long de la portière 20 à la verticale. La goulotte 206 permet d'accueillir le faisceau de connexions électriques 4. Elle l'oriente bien à la verticale. Le faisceau de connexions électriques 4 s'insère ainsi dans ladite goulotte 206. Il va se connecter au connecteur 25 dudit véhicule automobile 2 adapté pour connecter ledit faisceau de connexions électriques 4 à l'unité de contrôle 24 du véhicule automobile 2. Dans un mode de réalisation non limitatif, le connecteur 25 est adapté pour être disposé sur la portière 20.

Dans des variantes de réalisation non limitatives, le connecteur 25 est adapté pour être disposé à l'extérieur de la portière 20, comme le boîtier antenne 1, ou à l'intérieur de la portière 20. Dans un exemple non limitatif, il est disposé en dessous des deux vitres du véhicule automobile 2.

Le faisceau de connexions électriques 4 est adapté pour alimenter les composants électroniques 130 de ladite platine support secondaire 13 et pour véhiculer des signaux de commande vers l'unité de contrôle 24 du véhicule automobile 2. A cet effet, il comprend au moins trois fils dont un pour l'alimentation positive, un pour l'alimentation négative, et un pour véhiculer les signaux de commande. Dans un mode de réalisation non limitatif, les signaux de commande sont des signaux LIN (« Local Interconnect Network »). Ce protocole de communication LIN est un protocole de communication économique et couramment utilisé. Dans un autre mode de réalisation non limitatif, les signaux de commande sont des signaux CAN (« Controller Area Network »). Dans ce cas, le faisceau de connexions électriques 4 comprend un fils en plus, le protocole de communication CAN étant un protocole de communication bidirectionnel nécessitant un fil en plus.

Dans un mode de réalisation non limitatif, les signaux de commande comprennent l'autorisation d'accès véhicule sur confirmation d'un identifiant valide et le déverrouillage du véhicule automobile 2, à savoir en particulier de la portière 20. Dans un mode de réalisation, les signaux de commande peuvent en outre comprendre l'identification d'un identifiant du véhicule automobile. Ces signaux de commande sont envoyés si par exemple un utilisateur du véhicule automobile 2 possède le bon identifiant pour accéder au véhicule automobile 2 et a approché son identifiant à une certaine distance d'accès de l'endroit où se trouve le boîtier antenne 1, et en particulier de l'antenne 12 comprise dans ledit boîtier antenne 1. En pratique, l'utilisateur plaquera son identifiant sur le marquage d'identification qui se trouve sur la portière 20 à côté de la vitre et qui définit l'emplacement de l'antenne 12. On notera que la distance d'accès est définie par le type d'antenne 12 utilisé. Dans un mode de réalisation non limitatif, la distance d'accès NFC est de 30mm, plus ou moins 15mm.

Le faisceau de connexions électriques 4 est en outre adapté pour alimenter la platine support primaire 12 lorsqu'un contact électrique est établi entre la platine support secondaire 13 et la platine support primaire 12.

Les éléments du boîtier antenne 1 sont décrits en détail ci-dessous.

### • Platine support primaire 12

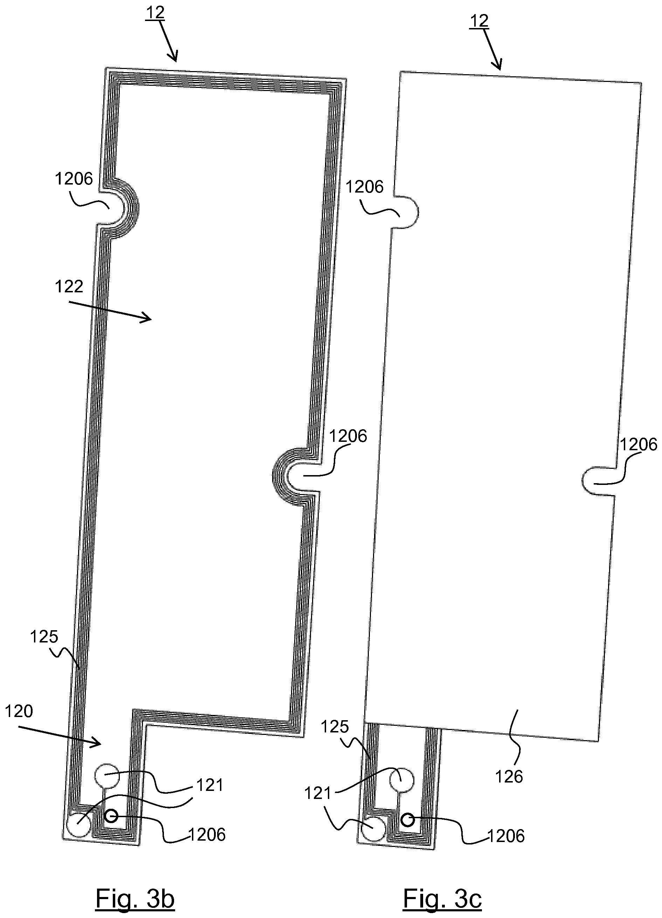

La platine support primaire 12 est illustrée sur la figure 1, et 3b et 3c.

Elle forme une antenne.

Dans un mode de réalisation non limitatif, l'antenne 12 est une antenne en champ propre NFC « Near Field Communication » en anglais. Ce mode de réalisation est pris comme exemple non limitatif dans la suite de la description. Le protocole de communication NFC utilise une bande de fréquence de 13,56 MHz.

La platine support primaire 12 est adaptée pour être disposée dans le réceptacle 10 du boîtier antenne 1.

Dans un premier mode de réalisation non limitatif, la platine support primaire 12 est une carte électronique flexible tel que dans un exemple non limitatif un « flexboard ». Dans un deuxième mode de réalisation non limitatif, la platine support primaire 12 est une carte à circuit imprimé telle que dans un exemple non limitatif une carte PCB « Printed Circuit Board » en anglais. Dans un exemple non limitatif, la carte PCB est de type FR4.

Dans un mode de réalisation non limitatif, la platine support primaire 12 comprend une hauteur d'environ 0,3mm.

Tel qu'illustré sur la figure 1, la platine support primaire 12 comprend :
- un corps avec une surface primaire 122 et une surface secondaire 123 opposée à la surface primaire 122 ;
- des pistes sérigraphiées 125 (illustrées sur la figure 3b) en partie sur la surface primaire 122 et en partie sur la zone de contact électrique 120 ;
- une ferrite 126 (illustrées sur la figure 3c) qui recouvre lesdites pistes sérigraphiées 125 sur la surface primaire 122 ;
- une zone de contact électrique 120.

Les pistes sérigraphiées 125 sont en cuivre dans un exemple non limitatif.

La surface secondaire 123 est adaptée pour être disposée en regard du réceptacle 10. Ladite surface primaire 122 est adaptée pour être disposée en regard de ladite platine support secondaire 13. La ferrite 126 est donc adaptée pour être disposée en regard de ladite platine support secondaire 13.

Dans un mode de réalisation non limitatif, la surface primaire 122 est plane et les pistes sérigraphiées 125 sont disposées sur ladite surface primaire 122 plane. Cela permet d'améliorer les performances de l'antenne 12.

La ferrite 126 permet :
- d'orienter les ondes magnétiques émises par l'antenne 12 dans une direction donnée, ici vers la garniture 22 et donc l'extérieur du véhicule automobile 2 ;
- de protéger l'antenne 12 contre le rayonnement électromagnétique, appelé rayonnement CEM, des composants électroniques 130 de la platine support secondaires 13. Elle sert ainsi de bouclier contre le rayonnement CEM.

L'antenne 12 est déportée par rapport à ladite platine support secondaire 13, à savoir elle n'est pas intégrée à ladite platine support secondaire 13. Ainsi, elle est éloignée des composants électroniques 130, ce qui augmente ses performances de communication. Elle est en effet moins impactée par le rayonnement CEM des composants électroniques 130. De plus, l'antenne 12 n'étant pas placée sur la platine support secondaire 13, cela permet une limitation de la surface utilisée par ladite platine support secondaire 13.

Dans un mode de réalisation non limitatif illustré figure 1, l'antenne 12 est positionnée contre le fond 109 du réceptacle 10. Dans un mode de réalisation non limitatif, elle est maintenue sur le fond 109 du réceptacle 10 par un film adhésif (non illustré), et ce sur toute sa surface. Cela permet d'éviter, qu'au moment du coulage de résine R, cette dernière ne vienne s'interposer entre le fond 109 du réceptacle 10 et l'antenne 12, ce qui risquerait de décoller ladite antenne 12. La platine support primaire 12 est ainsi collée sur le réceptacle 10 au moyen du film adhésif disposé sur la surface secondaire 123.

Dans un mode de réalisation non limitatif, la zone de contact électrique 120 est adaptée pour mettre en contact électrique ladite platine support primaire 12 et ladite platine support secondaire 13. Cela permet ainsi d'alimenter la platine support primaire 12 via la platine support secondaire 13, cette dernière étant en contact avec le faisceau de connexions électriques 4.

Dans un mode de réalisation non limitatif, la zone de contact électrique 120 comprend des zones métallisées 121, appelées « pad » en anglais. Dans un mode de réalisation non limitatif, ces zones métallisées 121 sont en cuivre.

Les zones métallisées 121 sont adaptées pour être disposés en regard des vias 131 de la platine support secondaire 13 décrite plus loin de sorte qu'un contact électrique soit établi via une matière conductrice liquide (non illustrée) tel que de l'étain dans un exemple non limitatif.

Dans un mode de réalisation non limitatif, la zone de contact électrique 120 comprend deux zones métallisées 121. Une zone métallisée 121 sert de contact électrique positif, et l'autre zone métallisée 121 sert de contact électrique négatif.

### • Platine support secondaire 13

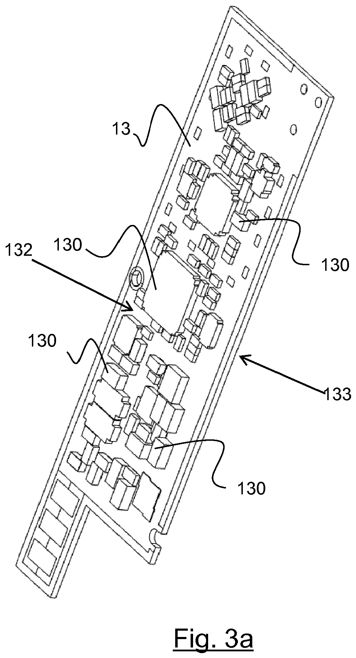

La platine support secondaire 13 est illustrée sur les figures 1 et 3.

Tel qu'illustrée sur la figure 1, la platine support secondaire 13 est adaptée pour être disposée dans le réceptacle 10 du boîtier antenne 1 et en regard de la platine support primaire 12.

Dans un mode de réalisation non limitatif, la platine secondaire 13 est une carte à circuit imprimé, appelée également PCBA (« Printed Circuit Board Assembly » en anglais).

La platine support secondaire 13 comprend des composants électroniques 130 adaptés pour coopérer avec l'antenne 12.

Ces composants électroniques 130 gèrent la communication NFC. Ils sont reliés à l'antenne 12 par les pistes sérigraphiées cuivrées via le contact électrique établi entre ladite antenne 12 et ladite platine support secondaire 13. Ces composants électroniques 130 permettent notamment d'analyser le signal de l'antenne 12 et de dialoguer avec l'unité de contrôle 24 du véhicule automobile 2.

Tel qu'illustré sur les figures 1 et 3, la platine support secondaire 13 comprend deux faces 132 et 133.

Les composants électroniques 130 sont disposés sur une seule face 132 ou 133 de la platine support secondaire 13 ou sur les deux faces 132 et 133.

Dans l'exemple non limitatif illustré sur la figure 3, les composants électroniques 130 sont disposés sur la face 132 opposée à la face 133 de la platine support secondaire 13 qui se trouve en regard de la surface primaire 122 de la platine support primaire 12.

Tel qu'illustrée sur la figure 1, la platine support secondaire 13 comprend des vias 131 adaptés pour coopérer avec lesdites zones métallisées 121 de la platine support primaire 12. Les vias 131 sont des trous métallisés.

Les vias 131 sont adaptés pour recevoir une matière conductrice liquide de sorte à faire le contact électrique entre ladite antenne 12 et ladite platine support secondaire 13. Une soudure est ainsi réalisée.

Dans un mode de réalisation non limitatif, la matière conductrice liquide est de l'étain. Dans un exemple non limitatif, une baguette d'étain est utilisée et chauffée au moyen d'une buse de chauffage ou d'un faisceau laser. La soudure à l'étain est suffisamment robuste pour résister à la traction liée à la résine R qui se dilate lorsqu'elle est chauffée. Ainsi le contact électrique n'est pas perdu lorsque la résine R chauffe.

Lorsque la matière conductrice est chauffée, elle fond, et devient la matière conductrice liquide qui va jusqu'au fond des vias 131 (car liquide) et fait ainsi le contact électrique entre les zones métallisées 121 et les vias 131.

### • Réceptacle 10

Le réceptacle 10 est illustré sur les figures 1, 2, 5, 6 à 8.

Dans un mode de réalisation non limitatif, le matériau du réceptacle 10 est du pbt (poly-téréphtalate de butylène). Il a la particularité de permettre une bonne adhésion cohésive avec la résine R et n'est pas très souple.

Tel qu'illustré sur la figure 1, il est adapté pour accueillir la platine support primaire 12 et la platine support secondaire 13.

Le réceptacle 10 est adapté pour être assemblé avec le couvercle 13 et permettre le coulage de la résine R par l'ouverture 14 du boitier antenne 1.

### ∘ Bord 103

Le réceptacle 10 comprend un bord 103 et un fond 109.

Le bord 103 permet avec le bord 113 du couvercle 11 de retenir la résine R dans le boîtier antenne 1.

Le bord 103 du réceptacle 10 comprend trois segments adjacents deux à deux dont un segment central et deux segments latéraux. Les deux segments latéraux sont non adjacents, sont situés en regard l'un de l'autre et sont sensiblement parallèles entre eux. Les trois segments du bord 103 sont adaptés à être en vis-à-vis de trois segments du bord 113 du couvercle 11.

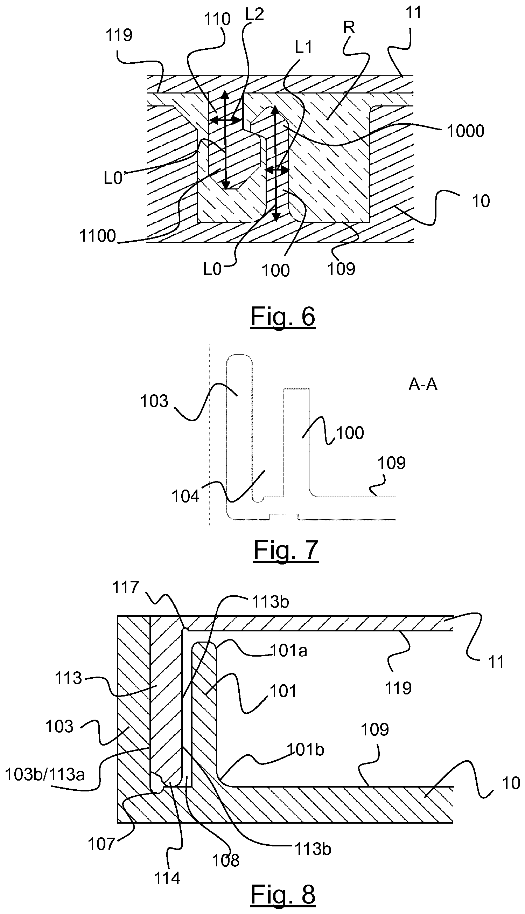

Tel qu'illustré sur la figure 8, la surface intérieure 103b des segments du bord 103 va ainsi être en contact avec la surface extérieure 113a du bord 113 du couvercle 11.

### ∘ Clip de fixation primaire 100

Le réceptacle 10 comprend au moins un clip de fixation primaire 100 adapté pour coopérer avec un clip de fixation secondaire 110 du couvercle 11. Ces clips de fixation primaire 100 et secondaire 110, en s'assemblant, maintiennent les deux parties du boitier antenne 1, à savoir le réceptacle 10, le couvercle 11, solidaires l'un de l'autre lors des phases d'assemblage du réceptacle 10 avec le couvercle 11 et de manipulation du boîtier antenne 1 lors du coulage de la résine R. Ils permettent ainsi un serrage du réceptacle 10 et du couvercle 11 de sorte que la résine R ne sorte pas.

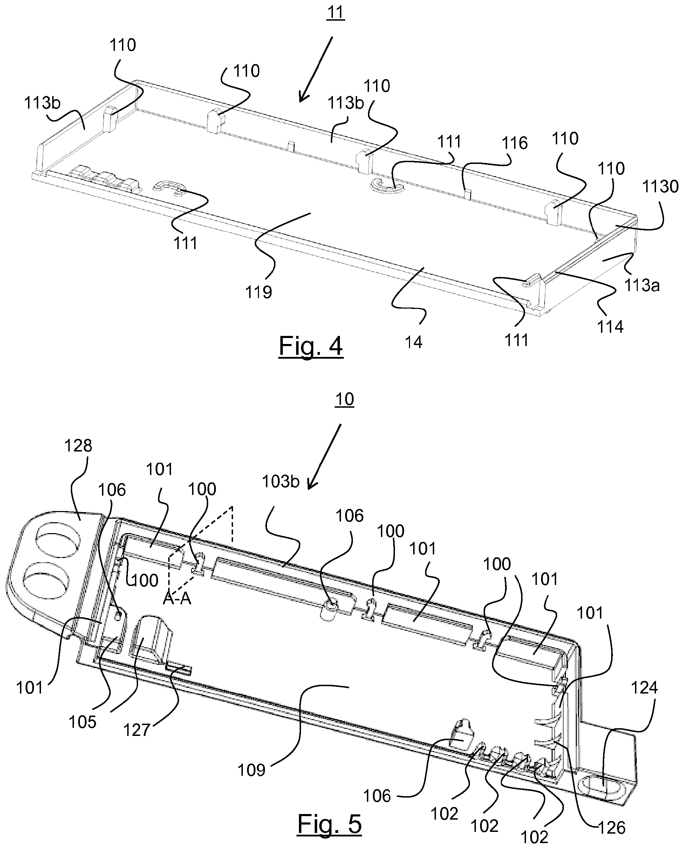

Dans mode de réalisation non limitatif illustré dans la figure 5, le réceptacle 10 comprend une pluralité de clips de fixation primaires 100. Cela permet de rendre l'assemblage plus robuste et ainsi d'éviter toute désolidarisation en phase de manipulation d'assemblage du réceptacle 10 avec le couvercle 11 et de coulage de résine R. La pluralité des clips de fixation 100 est répartie le long du bord 103 dudit réceptacle 10. Cela permet une meilleure répartition des contraintes de fixation du réceptacle 10 avec le couvercle 11.

Dans l'exemple non limitatif illustré sur la figure 5, le réceptacle 10 comprend cinq clips de fixation primaires 100 dont trois sur le segment central et un sur chaque segment latéraux du bord 103.

Ledit au moins un clip de fixation primaire 100 est libre, à savoir il n'est pas solidaire du bord 103. Il peut ainsi se déformer, et notamment fléchir.

Dans un mode de réalisation non limitatif illustré figure 6, le clip de fixation primaire 100 a des dimensions qui le rendent déformable pour que, lors de l'assemblage avec le clip de fixation secondaire 110, notamment sa tête 1000 (illustrée sur la figure 6) puisse bouger. Ainsi il comprend une largeur L1 inférieure à la largeur L2 du clip de fixation secondaire 110. On notera que la largeur L1 est la largeur du corps du clip de fixation primaire 100, le corps étant prolongé par la tête 1000. De plus, pour permettre cette déformation, sa longueur L0 est nettement supérieure à sa largueur L1. Dans un mode de réalisation non limitatif, sa largeur L1 est sensiblement égale à 1mm (millimètres).

Dans un mode de réalisation non limitatif illustré figure 6, le clip de fixation primaire 100 comprend une longueur L0 comprise entre 3,3mm et 3,8 mm.

La longueur L0 est déterminée pour répartir les contraintes lors de l'assemblage du couvercle 11 avec le réceptacle 11 de façon à éviter que lesdits clips de fixation primaire 100 et secondaire 110 ne cassent.

Dans un mode de réalisation non limitatif illustré figure 7, le réceptacle 10 comprend un espace primaire 104 entre ledit au moins un clip de fixation primaire 100 et le bord 103 dudit réceptacle 10. Ledit espace primaire 104 permet le passage du bord 113 (illustré sur la figure 4) du couvercle 11 lors de l'emboîtement du réceptacle 10 et du couvercle 11.

Par ailleurs, l'espace primaire 104 permet le passage de la résine R qui coule ainsi tout autour dudit au moins clip de fixation primaire 100. Cela permet de rendre plus robuste l'assemblage du réceptacle 10 avec le couvercle 11 après la polymérisation de la résine R.

Dans un mode de réalisation non limitatif illustré figure 7, l'espace primaire 104 est en forme de U. Cela augmente la surface d'adhésion entre la résine R et le boîtier antenne 1. L'augmentation de la surface d'adhésion permet de rendre plus robuste le boîtier antenne 1.

### o Muret 101

Dans un mode de réalisation non limitatif illustré dans la figure 5, le réceptacle 10 comprend en outre au moins un muret 101 disposé le long du bord 103. Le muret 101 permet d'augmenter la rigidité du réceptacle 10 dans les phases d'assemblage du réceptacle 10 avec le couvercle 11 et de manipulation du boîtier antenne 1 lors du coulage de la résine R. Il permet d'augmenter la robustesse du boîtier antenne 1 de sorte que ledit boîtier antenne 1 ne casse pas.

Par ailleurs, ledit au moins un muret 101 rajoute de la surface d'adhésion avec la résine R ce qui rend plus robuste le boîtier antenne 1 après la polymérisation de la résine R.

Dans un mode de réalisation non limitatif illustré figure 8, un espace secondaire 108 existe entre le bord 113 du couvercle 11 et le muret 101 du réceptacle 10 pour permettre à la résine R de couler dedans et ainsi solidariser à cet endroit le réceptacle 10 et le couvercle 11. La résine R coule donc autour du muret 101 ce qui rend plus robuste l'assemblage du réceptacle 10 avec le couvercle 11.

Ainsi, l'espace primaire 104 décrit précédemment et l'espace secondaire 108 permettent à la résine R de s'écouler tout le long du bord 103 du réceptacle 10 ce qui rend le boîtier antenne 1 plus robuste après la polymérisation de ladite résine R.

Ledit au moins un muret 101 est aligné avec les clips de fixation primaires 100. On utilise ainsi l'épaisseur du muret 101 pour intégrer les clips de fixation primaires 100. Cela permet de laisser un maximum d'espace pour l'électronique, à savoir les composants électroniques 130.

Ledit au moins un muret 101 comprend une tête 101a et une base 101b.

Dans un mode de réalisation non limitatif illustré sur la figure 8, la tête 101a est arrondie. Cela permet d'améliorer le coulage de la résine R vers l'espace secondaire 108 décrit précédemment.

Dans un mode de réalisation non limitatif illustré sur la figure 8, la base 101b comprend une courbure côté opposé au bord 103 du réceptacle 10. Cela permet d'améliorer le coulage de la résine R entre la platine primaire 12 et la platine secondaire 13.

Dans un mode de réalisation non limitatif illustré dans la figure 5, le réceptacle 10 comprend une pluralité de murets 101. Deux murets 101 sont répartis de part et d'autre d'un clip de fixation primaire 100. Un clip de fixation primaire 100 est ainsi entouré de deux murets 101. On a ainsi une alternance de murets 101 et de clips de fixation primaires 100.

Un muret 101 est distant des clips de fixation primaires 100 adjacents de sorte que la résine R puisse s'écouler autour desdits clips de fixation primaires 100 et rendent ainsi plus robuste l'assemblage du réceptacle 10 avec le couvercle 11.

On notera que le couvercle 11 s'emboîte dans le réceptacle 10 grâce à son bord 113 qui se place entre le bord 103 du réceptacle 10 et ses murets 101 lors de l'assemblage entre le couvercle 11 et le réceptacle 10.

Tel qu'illustré sur la figure 8, la tête 101a d'un muret 101 ne touche pas le fond du couvercle 11. Cela permet de laisser passer la résine R dans l'espace secondaire 108 et assurer que le contact soit bien fait au bout du bord 113 du couvercle 10. Cela permet d'assurer l'étanchéité au bout du bord 113 avant la polymérisation de ladite résine R.

### ∘ Griffe 102

Dans un mode de réalisation non limitatif illustré en figure 5, le réceptacle 10 comprend en outre au moins une griffe 102 adaptée pour passer le faisceau de connexions électriques 4. Dans l'exemple non limitatif illustré, le réceptacle 10 comprend quatre griffes 102 pour bloquer trois fils du faisceau de connexions électriques 4.

### o Gorge 107

Dans un mode de réalisation non limitatif illustré figure 8, le réceptacle 10 comprend en outre au moins une gorge 107 à l'angle du bord 103 et du fond 109 du réceptacle 10.

La gorge 107 permet, en cas de légère flexion du bord 103 lors de l'emboîtement dudit réceptacle 10 avec ledit couvercle 11, de limiter l'apparition d'un point de rupture à l'angle dudit bord 103 et dudit fond 109.

Ladite gorge 107 améliore donc la résistance à la déformation du bord 103 du réceptacle 10 dans les phases d'assemblage du réceptacle 10 avec le couvercle 11 et de manipulation du boîtier antenne 1 lors du coulage de résine R.

### ∘ Autres éléments

Dans un mode de réalisation non limitatif illustré figure 5, le réceptacle 10 comprend en outre un bossage 105 adapté pour recevoir la zone de contact électrique 120 décrite précédemment de la platine support primaire 12. Cela permet de maîtriser la distance entre les composants électroniques 130 et l'antenne 12 et pour laisser suffisamment d'espace pour la résine R.

Dans un mode de réalisation non limitatif illustré figure 5, le réceptacle 10 comprend en outre au moins un plot de positionnement 106 de la platine support primaire 12 et de la platine support secondaire 13 dans ledit réceptacle 10. Ledit au moins plot de positionnement 106 comprend une base sur laquelle peut reposer la platine support secondaire 13. Cela permet de laisser un espace entre la platine support primaire 12 et la platine support secondaire 13 pour couler la résine R.

Dans une variante de réalisation non limitative, ledit réceptacle 10 comprend trois plots de positionnement 106. Cela permet de faire un appui plan.

Dans un mode de réalisation non limitatif illustré figure 5, le réceptacle 10 comprend en outre une fenêtre de passage 124 pour le passage dudit faisceau de connexions électriques 4.

Dans un mode de réalisation non limitatif illustré figure 5, le réceptacle 10 comprend en outre un dispositif de fixation 128 sur la carrosserie 20 du véhicule automobile 2. Dans un mode de réalisation non limitatif, le dispositif de fixation est une patte de fixation qui s'étend en saillie par rapport au corps du réceptacle 10. Ladite patte de fixation comprend au moins un orifice. Un rivet (non illustré) peut ainsi être inséré en force dans un orifice de la patte de fixation 128 et passer au travers de la tôle de la portière 20 pour plaquer le boîtier antenne 1 contre ladite portière 20, sur la face extérieure 205 de ladite portière 20.

Dans un mode de réalisation non limitatif, le dispositif de fixation 128 comprend deux orifices pour accueillir un rivet dans un exemple non limitatif.

Cela permet de s'adapter au montant de portière (droite ou gauche) sur lequel est montée le boîtier antenne 1. On peut ainsi assembler l'antenne 12 dans les deux configurations.

Un rivet peut ainsi être inséré en force dans un orifice de la patte de fixation 128 et passer au travers de la tôle de la portière 20 pour plaquer le boîtier antenne 1 contre ladite portière 20, sur la face extérieure 205 de ladite portière 20.

Dans un mode de réalisation non limitatif illustré sur la figure 5, le réceptacle 10 comprend en outre une patte de maintien 127 de ladite platine support primaire 12. Elle permet de maintenir en position ladite platine support primaire 12 lorsque cette dernière a été placée dans le réceptacle 10.

Dans un mode de réalisation non limitatif illustré sur la figure 5, le réceptacle 10 comprend en outre au moins un contrefort 126 adapté pour rigidifier ledit le muret 101 dans la zone proche de la fenêtre de passage 124 pour la reprise d'effort des fils du faisceau de connexions électriques 4 qui passent dans ladite fenêtre de passage 124.

Dans une variante de réalisation non limitative, ledit au moins un contrefort 126 est disposé sur un muret 101. Cela permet d'augmenter la rigidité du boîtier antenne 1 assemblé pour tenir les contraintes d'arrachement des fils.

Dans l'exemple non limitatif illustré, il y a trois contreforts 126.

### • Couvercle 11

Le couvercle 11 est illustré sur les figures 1, 2, 4, 8.

Il est adapté pour s'emboiter avec le réceptacle 10 pour permettre le coulage de la résine R par l'ouverture 14. Ainsi, il est adapté pour fermer le boîtier antenne 1 de sorte à laisser une ouverture 14 (illustrée sur la figure 2) pour couler la résine R dans ledit boîtier antenne 1.

Dans un mode de réalisation non limitatif, le matériau du couvercle 11 est du pbt (poly-téréphtalate de butylène). Il a la particularité de permettre une bonne adhésion cohésive avec la résine R et n'est pas très souple.

### ∘ Bord 113

Le bord 113 est un muret qui fait le contour du couvercle 11.

Le bord 113 du couvercle 11 comprend trois segments adjacents deux à deux dont un segment central et deux segments latéraux. Les deux segments latéraux sont non adjacents, sont situés en regard l'un de l'autre et sont sensiblement parallèles entre eux. Les trois segments du bord 113 sont adaptés pour s'insérer entre le bord 103 du réceptacle 10 et les murets 101 dudit réceptacle de sorte que le couvercle 11 s'emboîte dans ledit réceptacle 10. Tel qu'illustré sur la figure 8, la surface extérieure 113a des segments du bord 113 va ainsi être en contact avec la surface intérieure 103b du bord 103 du réceptacle 10, tandis que la surface intérieure 113b des segments du bord 113 va se trouver en vis-à-vis des murets 101.

Dans un mode de réalisation non limitatif illustré sur la figure 4, le bord 113 comprend des godrons 116 adaptés pour plaquer ledit bord 113 localement sur le bord 103 très long du réceptacle 10. Dans un mode de réalisation non limitatif, les godrons 116 comprennent un chanfrein adapté pour pousser la surface extérieure 113a du bord 113 vers la surface intérieure 103b du bord 103. Cela permet d'assurer un bon contact entre le bord 113 et le bord 103, et un bon contact entre les godrons 114 (décrits plus loin) et le fond 109 du réceptacle 10. Cela évite ainsi que la résine R ne passe entre les deux surfaces extérieure 113a et intérieure 103b. Cela assure ainsi une bonne étanchéité.

### ∘ De plus, cela permet de laisser de l'espace pour que la résine R coule dans l'espace secondaire 108 illustré sur la figure 8.Clip de fixation secondaire 110

Le couvercle 11 comprend au moins un clip de fixation secondaire 110 adapté pour coopérer avec un clip de fixation primaire 100 du réceptacle 10.

Ces clips de fixation primaire 100 et secondaire 101, en s'assemblant, maintiennent les deux parties du boitier antenne 1, à savoir le réceptacle 10, le couvercle 11, solidaires l'un de l'autre lors des phases d'assemblage du réceptacle 10 avec le couvercle 11 et de manipulation du boîtier antenne 1 lors du coulage de la résine R.

Dans mode de réalisation non limitatif illustré dans la figure 4, le couvercle 11 comprend une pluralité de clips de fixation secondaires 110. Cela permet de rendre l'assemblage du réceptacle 10 et de couvercle 11 plus robuste et ainsi éviter toute désolidarisation d'assemblage du réceptacle 10 avec le couvercle 11 et de manipulation du boîtier antenne 1 lors du coulage de résine R. La pluralité des clips de fixation secondaires 110 est répartie le long du bord 113 dudit couvercle 11. Cela permet une meilleure répartition des contraintes de fixation du réceptacle 10 avec ledit couvercle 11.

Dans l'exemple non limitatif illustré sur la figure 4, le couvercle 11 comprend cinq clips de fixation secondaires 110 dont trois sur le segment central et un sur chaque segment latéraux du bord 113.

Dans un mode de réalisation non limitatif illustré figure 6, le clip de fixation secondaire 110 comprend des dimensions qui le rendent très peu déformable lors de l'assemblage avec le clip de fixation primaire 100. Ainsi, il comprend une largeur L2 qui est supérieure la largeur L1 du clip de fixation primaire 100. On notera que la largeur L2 est la largeur du corps du clip de fixation secondaire 110, le corps étant prolongé par sa tête 1100. Dans un mode de réalisation non limitatif, la largeur L2 et sensiblement égale à 1,2mm.

De plus, dans un mode de réalisation non limitatif, le clip de fixation secondaire 11 est solidarisé du bord 113 du couvercle 11 pour augmenter encore sa rigidité. Dans ce cas, il n'est pas déformable. Il n'y a ainsi pas d'espace entre ledit clip de fixation secondaire 110 et ledit bord 113. Ledit clip de fixation secondaire 110 est ainsi disposé contre ledit bord 113. Dans un mode de réalisation non limitatif illustré figure 6, le clip de fixation secondaire 110 comprend une longueur L0' comprise entre 3,3mm et 3,8mm.

La longueur L0' est déterminée pour répartir les contraintes lors de l'assemblage du couvercle 11 avec le réceptacle 11 de façon à éviter que lesdits clips de fixation primaire 100 et secondaire 110 ne cassent. On notera que la longueur L0' peut être égale à la longueur L0 du clip de fixation primaire 100.

### ∘ Gorge 117

Dans un mode de réalisation non limitatif illustré figure 8, le couvercle 11 comprend en outre au moins une gorge 117 à l'angle du bord 113 et du fond 119 du couvercle 11. La gorge 117 permet, en cas de légère flexion du bord 117 du couvercle 113 lors de l'emboîtement dudit couvercle 11 avec ledit réceptacle 10, de limiter l'apparition d'un point de rupture à l'angle dudit bord 113 et dudit fond 109. Ladite gorge 117 améliore donc la résistance à la déformation du bord 113 du couvercle 11 dans les phases d'assemblage du réceptacle 10 avec le couvercle 11 et de manipulation du boîtier antenne 1 lors du coulage de résine R.

### ∘ Contre-appui 111

Dans un mode de réalisation non limitatif illustré dans la figure 4, le couvercle 11 comprend en outre au moins un contre-appui 111 adapté pour appuyer sur la platine support secondaire 13 lorsque le boitier antenne 1 est fermé.

Dans l'exemple non limitatif illustré, le couvercle 11 comprend trois contre-appuis 111.

Ledit au moins un contre-appui 111 permet de maintenir la platine support secondaire 13 à une distance fixe du fond du couvercle 119 et permet d'exercer une pression pour garantir un bon contact électrique de la platine support primaire 12 avec la platine support secondaire 13.

Ledit au moins un contre-appui 111 permet de plaquer la platine support secondaire 13 sur les plots de positionnement 106 du réceptacle 10 pour éviter que ladite platine support secondaire 13 ne bouge lors du coulage de la résine R et avant et pendant sa polymérisation dans le boitier antenne 1, donc avant que la résine R ne fige la position de la platine support secondaire 13 après polymérisation.

### ∘ Godrons 114

Dans un mode de réalisation non limitatif illustré dans la figure 4 et 8, le bord 113 du couvercle 11 comprend en outre une pluralité de godrons 114 disposé le long du bord 113 dudit couvercle 11 sur une arrête 1130.

Un godron 114 forme un point de contact avec le fond 109 du réceptacle 10. Il permet ainsi de maitriser la métrologie car il existe une tolérance de planéité sur l'extrémité du godron 114.

Un godron 114 comprend moins de matière que le bord 113 où il se trouve ce qui le rend plus déformable à une pression exercée lors du coulage de la résine R. Par sa déformation locale, le godron 114 améliore l'étanchéité de la surface de contact du réceptacle 10 et du couvercle 11 afin que la résine R ne s'échappe pas lors de la coulée de ladite résine R.

Lorsqu'une pression est exercée sur le réceptacle 10 ou le couvercle 11 lors du coulage de la résine R, le contact est en effet bien établi grâce aux godrons 114 ce qui limite les fuites de résine R.

On notera que le fait d'avoir séparer le boîtier antenne 1 en deux parties, le réceptacle 10 et le couvercle 11, peut entraîner un « effet boîte » le long des bords 103 et 113 respectifs dudit réceptacle 10 et dudit couvercle 11, lesdits bords 103 et 113 étant assez longs. Cependant grâce au godrons 116, aux gorges 107, 117 et aux clips de fixation secondaires 110, on évite cet « effet boîte ».

### ∘ Autre élément

Tel qu'illustré sur la figure 2, dans un mode de réalisation non limitatif, le couvercle 11 comprend en outre un dispositif de pré-montage 17 sur la carrosserie 20. Le dispositif de pré-montage 17 est adapté pour pré-monter le boîtier antenne 1 sur la portière 20 avant son montage définitif, de manière à ce qu'il s'accroche sur ladite portière 20. Il est adapté pour s'insérer dans une fente (non illustrée) de la portière 20 prévue à cet effet.

### • Procédé d'assemblage P

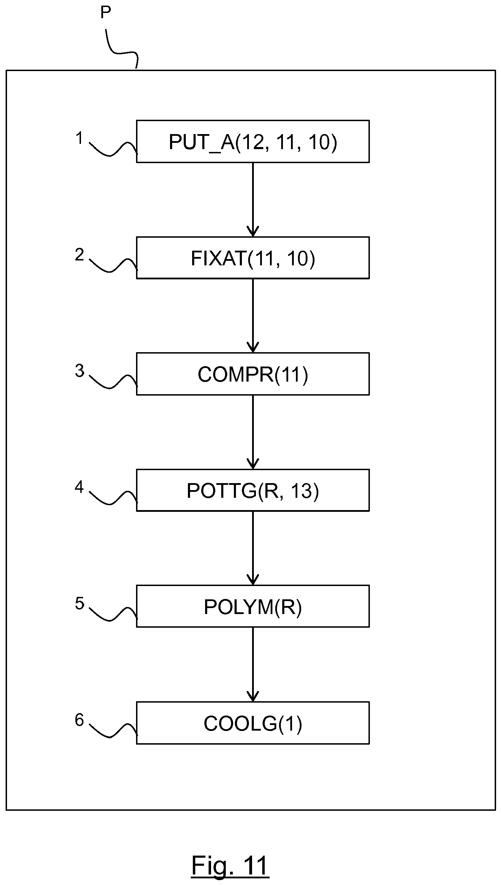

Le boîtier antenne 1 est assemblé de la manière suivante selon le procédé d'assemblage P illustré sur la figure 11, selon un mode de réalisation non limitatif, et décrit ci-après.

On notera que dans une étape initiale (non illustrée), le faisceau de connexions électriques 4 est inséré dans la fenêtre de passage 124 du réceptacle 10 et a été inséré dans les griffes 102 dudit réceptacle 10.

A l'étape 1) illustrée PUT_A(12, 11, 10), la platine support primaire 12 et la platine support secondaire 13 sont disposées dans le réceptacle 10 du boîtier antenne 1.

Le positionnement des deux platines support primaire 12 et secondaire 13 est réalisé grâce aux plots de positionnement 106.

La patte de maintien 127 maintient en position la platine support primaire 12 dans le réceptacle 10.

La zone de contact électrique 120 repose sur le bossage 105 du réceptacle 10.

Les vias 131 de la platine support secondaire 13 sont placés en regard des zones métallisées 121.

Une soudure (non illustrée) à l'étain dans un exemple non limitatif est réalisée entre les vias 131 et les zones métallisées 121 de sorte à réaliser le contact électrique entre la platine support secondaire 13 et la platine support primaire 12.

A l'étape 2) illustrée FIXAT(11, 10), le couvercle 11 est fixé sur ledit réceptacle 10 pour fermer ledit boîtier antenne 1 de sorte à laisser une ouverture 14 pour couler ladite résine R, ladite fixation étant réalisée au moyen dudit au moins un clip de fixation primaire 100 dudit réceptacle 10 qui coopère avec ledit au moins un clip de fixation secondaire 110 dudit couvercle 12. Dans un mode de réalisation non limitatif, la fixation est réalisée au moyen d'une pluralité de clips de fixation primaires 100 et d'une pluralité de clips de fixation secondaires 110.

Le couvercle 11 s'emboîte ainsi dans le réceptacle 10 de sorte que le bord 113 dudit couvercle 11 s'insère dans l'espace entre les murets 101 et les clips de fixation primaires 100, et le bord 103 du réceptacle 10, et de sorte que les clips de fixation primaires 100 et secondaires 101 se clipsent entre eux. Les clips de fixation secondaire 101 se déforment autour des clips de fixation primaires 100 qui eux restent rigides.

A l'étape 3) illustrée COMPR(11), le réceptacle 10 est mis en compression sur ledit couvercle 11 ou inversement. Dans un mode de réalisation non limitatif, la pression est exercée par un plateau plaqué par un ressort sur ledit réceptacle 10 ou couvercle 11.

Le couvercle 11 appuie sur la platine support secondaire 13 au moyen des contre-appuis 111, et les godrons 114 appuient sur le fond 109 du réceptacle 10. Ainsi, lors du coulage de la résine R (appelé « potting » en anglais), le contact entre le fond 109 du réceptacle 10 et le bord 113 du couvercle 11 est bien réalisé grâce aux godrons 114 ce qui limite les fuites de résine R.

A l'étape 4) illustrée POTTG(R, 13), la résine R est coulée dans ledit boîtier antenne 1 via ladite ouverture 14.

La résine R s'écoule dans tout le boîtier antenne 1, dans l'espace secondaire 108 derrière les murets 101 et dans l'espace primaire 104 derrière les clips de fixation primaires 100 de sorte à être tout autour des clips de fixations primaires 100 et en partie autour des clips de fixation secondaire 110. La résine R s'écoule également entre la platine support primaire 12 et la platine support secondaire 13. Ces dernières sont ainsi baignées dans ladite résine R.

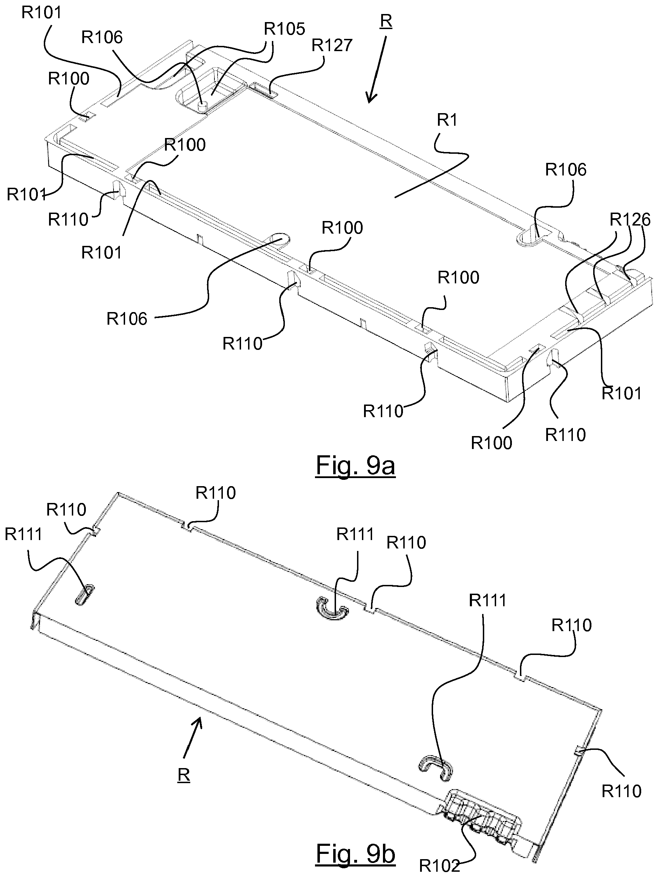

Une empreinte de la résine R ainsi coulée est illustrée sur les figures 9a et 9b.

Sur la figure 9a, on peut voir :
- la partie R1 de la résine R qui s'est écoulée entre la platine support primaire 12 et la platine support secondaire 13 ;
- le volume R101, autrement appelé négatif R101, laissé par les murets 101 dans la résine R ;
- le volume R100, autrement appelé négatif R100, laissé par les clips de fixation primaires 100 ;
- le volume R110, autrement appelé négatif R110, laissé par les clips de fixation secondaires 110 ;
- le volume R105, autrement appelé négatif R105, laissé par le bossage 105 ;
- le volume R106, autrement appelé négatif R106, laissé par les plots de positionnement 106 ;
- le volume R126, autrement appelé négatif R126, laissé par les contreforts 126 ;
- le volume R127, autrement appelé négatif R127, laissé par la patte de maintien 127.

Sur la figure 9b, on peut voir :
- le volume R110, autrement appelé négatif R110, laissé par les clips de fixation secondaires 110 ;
- le volume R102, autrement appelé négatif R102, laissé par les griffes 102 ;
- le volume R111, autrement appelé négatif R111, laissé par les contre-appuis 111.

Au cours de la manipulation du boîtier antenne 1 pour le coulage de la résine R, ni le réceptacle 10, ni le couvercle 11 ne se déforment, et ce grâce aux clips de fixation primaires 100 et secondaires 101.

A l'étape 5) illustrée POLYM(R), la résine R est polymérisée.

Le boîtier antenne 1 est ainsi passé au four pour polymériser la résine R. l'étape 6) illustrée COOLG(1), l'ensemble du boîtier antenne 1 est refroidi de sorte à refroidir la résine R.

Ainsi, après la polymérisation de la résine R, le boîtier antenne 1 est plus robuste. Il ne peut se casser. Même si on met en torsion ledit boîtier antenne 1, on ne peut déclipser les clips de fixation primaires 100 des clips de fixation secondaires 110 car la résine R qui se trouve tout autour maintient l'ensemble assemblé. De plus, même si on met en torsion ledit boîtier antenne 1, l'antenne 12 ne peut se décoller.

Bien entendu la description de l'invention n'est pas limitée à l'application, aux modes de réalisation et aux exemples décrits ci-dessus. Ainsi, dans un autre mode de réalisation non limitatif, l'antenne 12 est une antenne intégrée dans ladite platine support secondaire 13.

Ainsi, l'invention décrite présente notamment les avantages suivants :
- elle permet d'avoir un boîtier antenne 1 fin et robuste ;
- elle permet d'avoir un positionnement de l'antenne 12 et de la platine support secondaire 13 répétable ;
- elle permet de manipuler le boîtier antenne 1 sans que l'antenne 12 et la platine support secondaire 13 ne bougent ;
- elle permet de résiner correctement l'antenne 12 ;
- elle permet d'avoir un boîtier antenne1 en deux parties ce qui permet d'assembler une antenne 12 déportée de la platine support secondaire 13 qui comprend les composants électroniques 130 de sorte à laisser un espace entre elles. Ainsi, l'antenne 12 est éloignée des composants électroniques 130, ce qui augmente ses performances de communication. Elle est en effet moins impactée par le rayonnement CEM des composants électroniques 130. De plus, l'antenne 12 n'étant pas placée sur la platine support secondaire 13, cela permet une limitation de la surface utilisée par ladite platine support secondaire 13 et donc une réduction de sa taille ;
- elle permet de conserver le réceptacle 10 et le couvercle 11 assemblés quand ils sont manipulés lors du coulage de la résine R. Ils ne se désolidarisent pas ce qui permet d'éviter d'avoir des fuites de résine R ;
- elle permet de rendre plus robuste le boîtier antenne 1 grâce à la résine R qui passe autour des clips de fixation primaires 100 et en partie autour des clips de fixation secondaires 110 et autour des murets 101, une fois que ladite résine est polymérisée ;
- elle permet une bonne étanchéité du boîtier antenne 1 grâce à l'appui plan réalisé par les godrons 114 du couvercle 11 sur le fond 109 du réceptacle 10 ;
- elle permet de ne plus avoir « d'effet boîte » et par conséquent de rendre homogènes les performances de communication de l'antenne 12 d'un boîtier antenne 1 à un autre et donc d'un véhicule automobile à un autre.

## Revendications

1. Boîtier antenne (1) pour véhicule automobile (2) dans lequel une résine (R) à polymériser peut être coulée, selon lequel ledit boîtier antenne (1) comprend :
- un réceptacle (10) adapté pour accueillir une platine support primaire (12) et une platine support secondaire (13) et comprenant au moins un clip de fixation primaire (100) ;
- un couvercle (11) comprenant au moins un clip de fixation secondaire (110) adapté pour coopérer avec ledit au moins un clip de fixation primaire (100), ledit couvercle (11) étant adapté pour fermer ledit boîtier antenne (1) de sorte à laisser une ouverture (14) pour couler ladite résine (R) dans ledit boîtier antenne (1) ;
- ladite platine support primaire (12) formant une antenne ; et
- ladite platine support secondaire (13) adaptée pour être disposée en regard de ladite antenne (12) et comprenant des composants électroniques (130) adaptés pour coopérer avec ladite antenne (12),
**caractérisé en ce que** le réceptacle (10) comprend au moins un muret (101) disposé le long d'un bord (103) dudit réceptacle (10) de manière à augmenter la rigidité du réceptacle (10) dans les phases d'assemblage du réceptacle (10) avec le couvercle (11) et de manipulation du boîtier antenne (1) lors du coulage de la résine (R).

2. Boîtier antenne (1) selon la revendication 1, selon lequel ledit réceptacle (10) comprend une pluralité de clips de fixation primaires (100) et ledit couvercle (11) comprend une pluralité de clips de fixation secondaires (110).

3. Boîtier antenne (1) selon l'une quelconque des revendications précédentes 1 à 3, selon lequel ledit couvercle (11) comprend en outre au moins un contre-appui (111) adapté pour appuyer sur la platine support secondaire (13) lorsque ledit boîtier antenne (1) est fermé.

4. Boîtier antenne (1) selon l'une quelconque des revendications précédentes 1 à 4, selon lequel ledit couvercle (11) comprend en outre une pluralité de godrons (114) disposés le long d'un bord (113) dudit couvercle (11) sur une arrête (1130).

5. Boîtier antenne (1) selon l'une quelconque des revendications précédentes 1 à 5, selon lequel ledit réceptacle (10) comprend en outre au moins une griffe (102) adaptée pour passer un faisceau de connexions électriques (4).

6. Boîtier antenne (1) selon l'une quelconque des revendications précédentes 1 à 6, selon lequel ledit au moins un clip de fixation primaire (100) comprend une largeur (L1) inférieure à celle (L2) dudit au moins un clip de fixation secondaire (110).

7. Boîtier antenne (1) selon l'une quelconque des revendications précédentes 1 à 7, selon lequel ledit au moins un clip de fixation primaire (100) et ledit au moins un clip de fixation secondaire (110) comprennent une longueur (L0, L0') comprise entre 3,3 millimètres et 3,8 millimètres.

8. Boîtier antenne (1) selon l'une quelconque des revendications précédentes 1 à 8, selon lequel ledit réceptacle (10) comprend un espace primaire (104) entre ledit au moins un clip de fixation primaire (100) et un bord (103) dudit réceptacle (10).

9. Boîtier antenne (1) selon la revendication 8, selon lequel ledit espace primaire (104) est en forme de U.

10. Boîtier antenne (1) selon l'une quelconque des revendications précédentes 1 à 9, selon lequel ladite antenne (12) est une antenne en champ proche (NFC).

11. Boîtier antenne (1) selon l'une quelconque des revendications précédentes 1 à 10, selon lequel ladite antenne (12) est déportée par rapport à ladite platine support secondaire (13).

12. Boîtier antenne (1) selon l'une quelconque des revendications précédentes 1 à 11, selon lequel ladite platine support primaire (12) est une carte électronique flexible ou une carte à circuit imprimé (PCB).

13. Boitier antenne (1) selon une l'une quelconque des revendications précédentes 1 à 12, selon lequel ledit réceptacle (10) et/ou ledit couvercle (11) comprend une gorge (107/117).

14. Procédé d'assemblage (P) d'un boîtier antenne (1) pour véhicule automobile (2) selon la revendication 1, ledit boîtier antenne (1) étant adapté pour accueillir une platine support primaire (12) formant une antenne et une platine support secondaire (13), et dans lequel une résine (R) à polymériser peut être coulée, selon lequel ledit procédé d'assemblage (P) comprend :
- le positionnement de ladite platine support primaire (12) et de ladite platine support secondaire (13) dans un réceptacle (10) dudit boîtier antenne (1) ;
- la fixation d'un couvercle (11) sur ledit réceptacle (10) pour fermer ledit boîtier antenne (1) de sorte à laisser une ouverture (14) pour couler ladite résine (R), ladite fixation étant réalisée au moyen d'au moins un clip de fixation primaire (100) dudit réceptacle (10) coopérant avec au moins un clip de fixation secondaire (110) dudit couvercle (12) ;
- la mise en compression dudit réceptacle (10) sur ledit couvercle (11) ou inversement ;
- le coulage de ladite résine (R) dans ledit boîtier antenne (1) via ladite ouverture (14) ;
- la polymérisation de ladite résine (R) ;
- le refroidissement dudit boîtier antenne (1).

## Patentansprüche

1. Antennengehäuse (1) für ein Kraftfahrzeug (2), in welches ein zu polymerisierendes Harz (R) gegossen werden kann, wobei das Antennengehäuse (1) umfasst:
- einen Behälter (10), der dazu eingerichtet ist, eine primäre Trägerplatte (12) und eine sekundäre Trägerplatte (13) aufzunehmen, und wenigstens einen primären Befestigungsclip (100) umfasst;
- einen Deckel (11), der wenigstens einen sekundären Befestigungsclip (110) umfasst, der dazu eingerichtet ist, mit dem wenigstens einen primären Befestigungsclip (100) zusammenzuwirken, wobei der Deckel (11) dazu eingerichtet ist, das Antennengehäuse (1) so zu schließen, dass eine Öffnung (14) zum Gießen des Harzes (R) in das Antennengehäuse (1) gelassen wird;
- wobei die primäre Trägerplatte (12) eine Antenne bildet; und
- wobei die sekundäre Trägerplatte (13) dazu eingerichtet ist, gegenüber der Antenne (12) angeordnet zu werden, und elektronische Bauteile (130) umfasst, die dazu eingerichtet sind, mit der Antenne (12) zusammenzuwirken,
**dadurch gekennzeichnet, dass** der Behälter (10) wenigstens ein Wandstück (101) umfasst, das entlang eines Randes (103) des Behälters (10) angeordnet ist, um so die Steifigkeit des Behälters (10) in den Phasen des Zusammenbaus des Behälters (10) mit dem Deckel (11) und der Handhabung des Antennengehäuses (1) beim Gießen des Harzes (R) zu erhöhen.

2. Antennengehäuse (1) nach Anspruch 1, wobei der Behälter (10) mehrere primäre Befestigungsclips (100) umfasst und der Deckel (11) mehrere sekundäre Befestigungsclips (110) umfasst.

3. Antennengehäuse (1) nach einem der vorhergehenden Ansprüche 1 bis 3, wobei der Deckel (11) außerdem wenigstens ein Widerlager (111) umfasst, das dazu eingerichtet ist, auf die sekundäre Trägerplatte (13) zu drücken, wenn das Antennengehäuse (1) geschlossen ist.

4. Antennengehäuse (1) nach einem der vorhergehenden Ansprüche 1 bis 4, wobei der Deckel (11) außerdem mehrere Leisten (114) umfasst, die entlang eines Randes (113) des Deckels (11) an einer Kante (1130) angeordnet sind.

5. Antennengehäuse (1) nach einem der vorhergehenden Ansprüche 1 bis 5, wobei der Behälter (10) außerdem wenigstens eine Klemme (102) umfasst, die dazu eingerichtet ist, ein elektrisches Leitungsbündel (4) hindurchzuführen.

6. Antennengehäuse (1) nach einem der vorhergehenden Ansprüche 1 bis 6, wobei der wenigstens eine primäre Befestigungsclip (100) eine Breite (L1) aufweist, die kleiner als diejenige (L2) des wenigstens einen sekundären Befestigungsclips (110) ist.

7. Antennengehäuse (1) nach einem der vorhergehenden Ansprüche 1 bis 7, wobei der wenigstens eine primäre Befestigungsclip (100) und der wenigstens eine sekundäre Befestigungsclip (110) eine Länge (L0, L0') zwischen 3,3 Millimetern und 3,8 Millimetern aufweisen.

8. Antennengehäuse (1) nach einem der vorhergehenden Ansprüche 1 bis 8, wobei der Behälter (10) einen primären Raum (104) zwischen dem wenigstens einen primären Befestigungsclip (100) und einem Rand (103) des Behälters (10) umfasst.

9. Antennengehäuse (1) nach Anspruch 8, wobei der primäre Raum (104) U-förmig ist.

10. Antennengehäuse (1) nach einem der vorhergehenden Ansprüche 1 bis 9, wobei die Antenne (12) eine Nahfeldantenne (NFC-Antenne) ist.

11. Antennengehäuse (1) nach einem der vorhergehenden Ansprüche 1 bis 10, wobei die Antenne (12) in Bezug auf die sekundäre Trägerplatine (13) versetzt ist.

12. Antennengehäuse (1) nach einem der vorhergehenden Ansprüche 1 bis 11, wobei die primäre Trägerplatine (12) eine flexible elektronische Karte oder eine Leiterplatte (PCB) ist.

13. Antennengehäuse (1) nach einem der vorhergehenden Ansprüche 1 bis 12, wobei der Behälter (10) und/oder der Deckel (11) eine Auskehlung (107/117) umfassen.

14. Verfahren zum Zusammenbau (P) eines Antennengehäuses (1) für ein Kraftfahrzeug (2) nach Anspruch 1, wobei das Antennengehäuse (1) dazu eingerichtet ist, eine primäre Trägerplatte (12), die eine Antenne bildet, und eine sekundäre Trägerplatte (13) aufzunehmen, und wobei ein zu polymerisierendes Harz (R) in dieses gegossen werden kann, wobei das Verfahren zum Zusammenbau (P) umfasst:
- die Positionierung der primären Trägerplatte (12) und der sekundären Trägerplatte (13) in einem Behälter (10) des Antennengehäuses (1);
- die Befestigung eines Deckels (11) auf dem Behälter (10) zum Schließen des Antennengehäuses (1), derart, dass eine Öffnung (14) zum Gießen des Harzes (R) gelassen wird, wobei die Befestigung mittels wenigstens eines primären Befestigungsclips (100) des Behälters (10) durchgeführt wird, der mit wenigstens einem sekundären Befestigungsclip (110) des Deckels (12) zusammenwirkt;
- das Andrücken des Behälters (10) an den Deckel (11), oder umgekehrt;
- das Gießen des Harzes (R) in das Antennengehäuse (1) über die Öffnung (14);
- die Polymerisation des Harzes (R);
- die Abkühlung des Antennengehäuses (1).

## Claims

1. Antenna housing (1) for a motor vehicle (2), into which a resin (R) to be polymerized can be poured, wherein said antenna housing (1) comprises:
- a receptacle (10) suitable for accommodating a primary support plate (12) and a secondary support plate (13) and comprising at least one primary fastening clip (100);
- a cover (11) comprising at least one secondary fastening clip (110) suitable for cooperating with said at least one primary fastening clip (100), said cover (11) being suitable for closing said antenna housing (1) so as to leave an opening (14) for pouring said resin (R) into said antenna housing (1);
- said primary support plate (12) forming an antenna; and
- said secondary support plate (13) suitable for being disposed facing said antenna (12) and comprising electronic components (130) suitable for cooperating with said antenna (12),
**characterized in that** the receptacle (10) comprises at least one low wall (101) disposed along a border (103) of said receptacle (10) so as to increase the stiffness of the receptacle (10) in the phases of joining the receptacle (10) to the cover (11) and of manipulating the antenna housing (1) during pouring of the resin (R).

2. Antenna housing (1) according to Claim 1, wherein said receptacle (10) comprises a plurality of primary fastening clips (100) and said cover (11) comprises a plurality of secondary fastening clips (110).

3. Antenna housing (1) according to any one of the preceding Claims 1 to 3, wherein said cover (11) also comprises at least one counter-support (111) suitable for pressing on the secondary support plate (13) when said antenna housing (1) is closed.

4. Antenna housing (1) according to any one of the preceding Claims 1 to 4, wherein said cover (11) also comprises a plurality of gadroons (114) disposed along a border (113) of said cover (11) on an edge (1130).

5. Antenna housing (1) according to any one of the preceding Claims 1 to 5, wherein said receptacle (10) also comprises at least one claw (102) suitable for passing a bundle of electrical connections (4) through it.

6. Antenna housing (1) according to any one of the preceding Claims 1 to 6, wherein said at least one primary fastening clip (100) has a width (L1) smaller than that (L2) of said at least one secondary fastening clip (110).

7. Antenna housing (1) according to any one of the preceding Claims 1 to 7, wherein said at least one primary fastening clip (100) and said at least one secondary fastening clip (110) have a length (L0, L0') of between 3.3 millimetres and 3.8 millimetres.

8. Antenna housing (1) according to any one of the preceding Claims 1 to 8, wherein said receptacle (10) comprises a primary space (104) between said at least one primary fastening clip (100) and a border (103) of said receptacle (10).

9. Antenna housing (1) according to Claim 8, wherein said primary space (104) is U-shaped.

10. Antenna housing (1) according to any one of the preceding Claims 1 to 9, wherein said antenna (12) is a near-field (NFC) antenna.

11. Antenna housing (1) according to any one of the preceding Claims 1 to 10, wherein said antenna (12) is remote from said secondary support plate (13).

12. Antenna housing (1) according to any one of the preceding Claims 1 to 11, wherein said primary support plate (12) is a flexible circuit board or a printed circuit board (PCB).

13. Antenna housing (1) according to any one of the preceding Claims 1 to 12, wherein said receptacle (10) and/or said cover (11) comprises a groove (107/117).

14. Method (P) for assembling an antenna housing (1) for a motor vehicle (2) according to Claim 1, said antenna housing (1) being suitable for accommodating a primary support plate (12) forming an antenna and a secondary support plate (13), and into which a resin (R) to be polymerized can be poured, wherein said assembly method (P) comprises:
- positioning said primary support plate (12) and said secondary support plate (13) in a receptacle (10) of said antenna housing (1);
- fastening a cover (11) to said receptacle (10) in order to close said antenna housing (1) so as to leave an opening (14) for pouring said resin (R), said fastening being realized by at least one primary fastening clip (100) of said receptacle (10) cooperating with at least one secondary fastening clip (110) of said cover (12);
- compressing said receptacle (10) onto said cover (11) or vice versa;
- pouring said resin (R) into said antenna housing (1) via said opening (14);
- polymerizing said resin (R);
- cooling said antenna housing (1).
